# EUROPEAN PATENT APPLICATION

(11) **EP 2 910 621 A1**
(43) Date of publication of application: **26.08.2015**
(21) Application number: 15153424.5
(22) Date of filing: 02.02.2015
(51) Int. Cl.: C09K 11/64

(54) **PHOSPHOR, LIGHT-EMITTING DEVICE AND METHOD FOR PRODUCING PHOSPHOR**

(30) Priority: 25.02.2014 JP 2014034258
(71) Applicant: Kabushiki Kaisha Toshiba, Tokyo 105-8001 (JP)
(72) Inventor: Fukuda, Yumi, Tokyo, 105-8001 (JP); Albessard, Keiko, Tokyo, 105-8001 (JP); Ishida, Kunio, Tokyo, 105-8001 (JP); Kato, Masahiro, Tokyo, 105-8001 (JP)
(74) Representative: Hoffmann Eitle

(57) **Abstract**

The embodiment of the present disclosure provides a yellow light-emitting phosphor represented by the formula (1): ((SrₚM₁₋ₚ)₁₋ₓCeₓ)_{2y}Al_{z}Si_{10-z}OᵤN_{w}. In the formula, M is at least one of the alkaline earth metals, and p, x, y, z, u and w are numbers satisfying the conditions of 0≤p≤1, 0<x≤1, 0.8≤y≤1.1, 2≤z≤3.5, 0<u≤1, 1.8≤z-u and 13≤u+w≤15. The emission peak of the phosphor shifts within a range of less than 15 nm when the peak of exciting light is changed in the range of 350 to 475 nm.

## Description

### FIELD

Embodiments of the present disclosure relate to a phosphor, a light-emitting device and a method for producing the phosphor.

### BACKGROUND

A white light-emitting device comprises a combination of, for example, a blue LED, a phosphor that emits red light under excitation by blue light, and another phosphor that emits green light under excitation by blue light. However, if containing a phosphor that emits yellow light under excitation by blue light, the white light-emitting device can be produced by use of fewer kinds of phosphors. As an example of the phosphors emitting yellow light under excitation by blue light, Ce-activated Sr-containing SiAION phosphors are known.

### BRIEF DESCRIPTION OF THE DRAWINGS

Figures 1A to 1C show the crystal structure of Sr₂Al₃Si₇ON₁₃.
Figure 2 shows a sectional view schematically illustrating the constitution of a light-emitting device according to an embodiment.
Figure 3 shows a sectional view schematically illustrating the constitution of a light-emitting device according to another embodiment.
Figure 4 shows the XRD profile of the phosphor produced in Example 1.
Figure 5 shows the emission spectrum of the phosphor produced in Example 1.
Figure 6 shows the XRD profile of the phosphor produced in Example 2.
Figure 7 shows the emission spectrum of the phosphor produced in Example 2.
Figure 8 shows relations between the emission wavelengths and the luminous efficiencies of the phosphors produced in Examples and Comparative examples.
Figure 9 shows relations between the emission peak wavelengths and the excitation peak wavelengths of the phosphors produced in Example 1 and Comparative example 1.
Figure 10 shows chromaticity diagrams of the phosphors produced in Examples and Comparative examples.

### DETAILED DESCRIPTION

Embodiments will now be explained with reference to the accompanying drawings.

The phosphor according to an embodiment of the present disclosure emits luminescence with an emission peak in the wavelength range of 500 to 600 nm under excitation by exciting light having a peak in the wavelength range of 250 to 500 nm, and is represented by the following formula (1):

((SrₚM₁₋ₚ)₁₋ₓCeₓ)_{2y}Al_{z}Si_{10-z}OᵤN_{w} (1)

in which
M is at least one of the alkaline earth metals, and p, x, y, z, u and w are numbers satisfying the conditions of
0≤p≤1,
0<x≤1,
0.8≤y≤1.1,
2≤z≤3.5,
0<u≤1,
1.8≤z-u, and
13≤u+w≤15.

Said emission peak shifts within a range of less than 15 nm when said peak of exciting light is changed in the range of 350 to 475 nm.

The embodiment will be explained below in detail.

Since showing luminescence with a peak wavelength of 500 to 600 nm under excitation by exciting light with a peak wavelength of 250 to 500 nm, the phosphor according to the embodiment can emit light in yellowish green to orange range. This kind of phosphor thus radiates light mainly in yellow range, and hence is hereinafter referred to as a "yellow light-emitting phosphor". The yellow light-emitting phosphor of the embodiment has a matrix of essentially the same crystal structure as that of Sr₂Al₃Si₇ON₁₃, and the matrix is activated with Ce. Specifically, the yellow light-emitting phosphor according to the embodiment is represented by the following formula (1):

((SrₚM₁₋ₚ)₁₋ₓCeₓ)_{2y}Al_{z}Si_{10-z}OᵤN_{w} (1).

In the formula, M is at least one of the alkaline earth metals, and p, x, y, z, u and w are numbers satisfying the conditions of
0≤p≤1,
0<x≤1,
0.8≤y≤1.1,
2≤z≤3.5,
0<u≤1,
1.8≤z-u, and
13≤u+w≤15.

As shown in the above formula (1), the metal element constituting the phosphor crystal is partly replaced with the emission center element Ce. The metal element M is at least one of the alkaline earth metals, and preferably at least one element selected from the group consisting of Ba, Ca and Mg. Even if the crystal contains at least one selected from the group consisting of Ba, Ca and Mg, formation of other phases is not promoted provided that p is as small as 0.1 or less. In some cases, p is preferably 1 so as to optimize luminescent properties of the phosphor. However, even in those cases, the crystal may contain unavoidable impurities, such as Sr and metals other than Ce. The phosphor of that crystal generally shows the effect of the present disclosure.

If M is replaced with Ce in an amount of at least 0.1 mol%, the phosphor can have sufficient luminous efficiency. The metal element M may be completely replaced with Ce (that is, x may be 1), but decrease of the emission probability (concentration quenching) can be avoided to the utmost if x is less than 0.5. Accordingly, x is preferably 0.001 to 0.5 inclusive. The phosphor of the embodiment contains Ce as an emission center, and thereby emits light in the range of yellowish green to orange, namely, luminescence with a peak in the wavelength range of 500 to 600 nm, under excitation by exciting light with a peak in the wavelength range of 250 to 500 nm. Even if other elements such as Tb, Eu and Mn are contained as unavoidable impurities in an amount of about 10 at.% or less, based on the amount of Ce, they does not impair the aimed effect.

If y is less than 0.8, crystal defects are increased to lower the efficiency. On the other hand, if y is more than 1.1, excess of the alkaline earth metal may deposit in the form of other phases to deteriorate the luminescent properties. Accordingly, y is preferably 0.85 to 1.06 inclusive.

If z is less than 2, excess Si may deposit in the form of other phases to deteriorate the luminescent properties. On the other hand, if z is more than 3.5, excess Al may deposit in the form of other phases to deteriorate the luminescent properties. Accordingly, z is preferably 2.5 to 3.3 inclusive.

If u is more than 1, crystal defects are increased to lower the efficiency. Accordingly, u is preferably 0.001 to 0.8 inclusive.

If the value of z-u is less than 1.8, the phosphor of the embodiment cannot keep the crystal structure and occasionally other phases are formed, so that the effect of the embodiment cannot be obtained. Similarly, if the value of u+w is less than 13 or more than 15, the phosphor of the embodiment cannot keep the crystal structure and occasionally other phases are formed, so that the effect of the embodiment cannot be obtained. Accordingly, the values of z-u and u+w are preferably 2 or more and 13.2 to 14.2 inclusive, respectively.

Since satisfying all the above conditions, the phosphor according to the present embodiment can efficiently emit yellow light with a wide half-width emission spectrum under excitation by exciting light with a peak in the wavelength range of 250 to 500 nm. As a result, the phosphor enables to realize white light of high color rendering property. Further, the yellow light-emitting phosphor of the present embodiment is also excellent in temperature dependence.

The yellow light-emitting phosphor according to the present embodiment is based on Sr₂Al₃Si₇ON₁₃, but its constituting elements Sr, Si, Al, O and N can be replaced with other elements and/or Ce to form a solid solution with the matrix. These modifications, such as replacement, often change the crystal structure. However, the atomic positions therein are only slightly changed so that the chemical bonds do not break. Here, the atomic positions depend on the crystal structure, on the sites occupied by the atoms therein and on their atomic coordinates.

The embodiment of the present disclosure leads to the aimed effect as long as the yellow-light emitting phosphor does not change its basic crystal structure. There may be a case where the crystal structure of the phosphor differs from that of Sr₂Al₃Si₇ON₁₃ in the lattice constants and/or in the chemical bond lengths (close interatomic distances) of M-N and M-O. However, even in that case, if the differences are within a range of ±15% based on the lattice constants or chemical bond lengths (Sr-N and Sr-O) in Sr₂Al₃Si₇ON₁₃, the crystal structure is defined to be the same. Here, the lattice constants can be determined by X-ray diffraction or neutron diffraction, and the chemical bond lengths (close interatomic distances) of M-N and M-O can be calculated from the atomic coordinates.

The Sr₂Al₃Si₇ON₁₃ crystal belongs to a monoclinic system, especially to an orthorhombic system with lattice constants of, for example, a=11.8 Å, b=21.6 Å and c=5.01 Å. This crystal belongs to the space group Pna21. The chemical bond lengths (Sr-N and Sr-O) in Sr₂Al₃Si₇ON₁₃ can be calculated from the atomic coordinates shown in Table 1.

**Table 1**

| element | x | y | z |
|---|---|---|---|
| Sr1 | 0.27857(6) | 0.49070(3) | 0.31162(19) |
| Sr2 | 0.35525(6) | 0.69834(3) | 0.7914(3) |
| Si, Al1 | 0.35788(16) | 0.27697(9) | 0.7909(7) |
| Si, Al2 | 0.07865(16) | 0.70029(8) | 0.7915(7) |
| Si, Al3 | 0.19194(16) | 0.63952(8) | 0.3041(7) |
| Si, Al4 | 0.00358(16) | 0.54352(8) | 0.2927(7) |
| Si, Al5 | 0.55677(16) | 0.46692(8) | 0.2985(7) |
| Si, Al6 | 0.39467(17) | 0.34711(9) | 0.2903(7) |
| Si, Al7 | 0.16173(16) | 0.56553(8) | -0.1922(7) |
| Si, Al8 | 0.47243(16) | 0.60941(8) | 0.2992(8) |
| Si, Al9 | 0.1546(3) | 0.34817(13) | 0.5289(6) |
| Si, Al10 | 0.1553(3) | 0.34966(14) | 0.0231(6) |
| O, N1 | 0.0664(5) | 0.3167(3) | 0.280(2) |
| O, N2 | 0.2530(5) | 0.3749(3) | 0.283(2) |
| O, N3 | 0.2131(5) | 0.2983(3) | 0.773(2) |
| O, N4 | 0.1015(5) | 0.3996(3) | -0.235(2) |
| O, N5 | 0.4050(6) | 0.2731(3) | 0.4571(16) |
| O, N6 | 0.3621(6) | 0.2067(3) | 0.9695(17) |
| O, N7 | 0.4919(6) | 0.3985(3) | 0.4519(17) |
| O, N8 | 0.4389(6) | 0.3335(3) | 0.9582(16) |
| O, N9 | 0.3356(5) | 0.6342(3) | 0.3472(15) |
| O, N10 | 0.0545(6) | 0.5193(3) | -0.0253(17) |
| O, N11 | 0.1600(6) | 0.6423(3) | -0.0419(16) |
| O, N12 | 0.1259(6) | 0.5734(3) | 0.4586(17) |
| O, N13 | 0.4887(6) | 0.5338(3) | 0.4528(17) |
| O, N14 | 0.7036(5) | 0.4688(3) | 0.331(2) |

The yellow light-emitting phosphor according to the present embodiment has the above crystal structure.

The yellow light-emitting phosphor of the present embodiment is based on an inorganic compound having the same crystal structure as Sr₂Al₃Si₇ON₁₃, but the constituting element M is partly replaced with the emission center element Ce and the amount of each element is restricted. On those conditions, the phosphor according to the present embodiment has high luminous efficiency and shows a wide half-width emission spectrum, and also has favorable properties, such as, excellent temperature dependence.

Conventional yellow light-emitting phosphors having the above crystal structure are characterized in that their emission wavelengths shift when the excitation peak wavelength is changed. However, the yellow light-emitting phosphor of the present embodiment is characterized in that the emission wavelength thereof only slightly shifts according to change of the excitation peak wavelength. Specifically, yellow light-emitting phosphors disclosed in WO2007/037059 emit luminescence with the peak that shifts by 20 nm or more when the excitation peak wavelength is changed in the range of 350 to 470 nm, where the exciting light generally excites yellow light-emitting phosphors. In contrast, the yellow light-emitting phosphor of the embodiment emits luminescence with the peak that shifts within a range as small as less than 15 nm, preferably less than 10 nm. Consequently, the yellow light-emitting phosphor according to the present embodiment can radiate light with excellent chromaticity. Further, when used in a white light-emitting device, the yellow light-emitting phosphor of the present embodiment can be blended in an amount small enough to reduce scattering loss caused by the phosphor and thereby enables to increase brightness of the white light.

In measuring the emission peak wavelength while changing the peak wavelength of light for exciting the phosphor, it is preferred for the exciting light to have a spectrum as sharp as possible. Specifically, if the exciting light has a spectrum with an unchanged peak wavelength but with a largely changed half-width, the phosphor may show an emission spectrum with a changed peak wavelength. Accordingly, the exciting light preferably has a spectrum with a half-width of 20 nm or less.

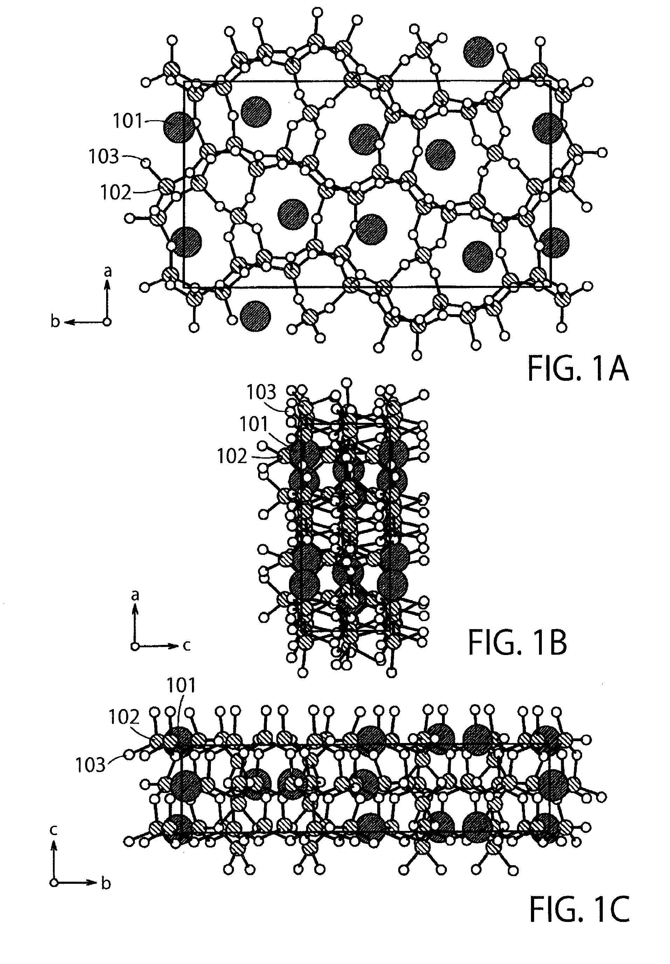

The crystal structure of Sr₂Al₃Si₇ON₁₃ based on the atomic coordinates in Table 1 is illustrated in Figures 1A to 1C. Figures 1A, 1B and 1C are projections of the crystal structure along the c, b and a axes, respectively. In Figures, 301 represents a Sr atom, which is surrounded by a Si or an Al atom 302 and an O or a N atom 303. The Sr₂Al₃Si₇ON₁₃ crystal can be identified by XRD or neutron diffraction.

The phosphor of the present embodiment has a composition represented by the above formula (1), and shows peaks at particular diffraction angles (2θs) in the X-ray diffraction profile measured with Cu-Kα line radiation according to Bragg-Brendano method. This means that its XRD profile has at least ten peaks in the diffraction angles (2θs) of 8.45-8.75°, 11.1-11.4°, 18.2-18.5°, 19.7-20.0°, 23.0-23.3°, 24.8-25.1°, 25.65-25.95°, 26.55-26.85°, 29.3-29.6°, 29.8-30.1°, 30.2-30.5°, 30.9-31.2°, 31.55-31.85°, 33.55-33.85°, 33.9-34.2°, 34.35-34.65°, 35.2-35.5°, 36.0-36.3°, 36.5-36.8°, 48.3-48.6°, and 48.7-49.0°.

The yellow-light emitting phosphor according to the present embodiment can be produced by the steps of mixing the raw materials containing the above elements and then firing the mixture.

The material containing Sr can be selected from a silicide, a nitride or a carbide of Sr, and is preferably a silicide of Sr; the material containing M can be selected from a silicide, a nitride or a carbide of M, and is preferably a silicide of M; the material containing Al can be selected from a nitride, an oxide or a carbide of Al; the material containing Si can be selected from a nitride, an oxide or a carbide of Si; and the material containing the emission center Ce can be selected from an oxide, a nitride or a carbonate of Ce.

In addition, nitrogen can be supplied from the above nitrides or from a nitrogen-containing firing atmosphere, and oxygen can be supplied from the above oxides or from the oxidized surface of the above nitrides particles.

For example, SrSi₂, Si₃N₄, Al₂O₃ and AIN, and CeO₂ are mixed in appropriate amounts to give the aimed composition. SrSi₂ may be replaced with Sr₃N₂, Sr₂N, SrN or its mixture. However, the more SrSi₂ is incorporated, the more the luminescent properties of the phosphor tend to be improved. That is presumed to be because, the more SrSi₂ is incorporated, the more evenly the phosphor particles are formed. Further, it is also effective in improving the evenness of the phosphor to improve the evenness of the raw material mixture. For the purpose of obtaining the homogeneous powder mixture, the raw materials in powder form are preferably dry-mixed in the order of smaller to larger weights.

The materials are mixed, for example, in a mortar in the atmosphere. The mixed powder is placed in a crucible and then fired on particular conditions to obtain the phosphor of the embodiment. There are no particular restrictions in the materials of the crucible, which is made of, for example, boron nitride, silicon nitride, silicon carbide, carbon, aluminum nitride, SiAION, aluminum oxide, molybdenum or tungsten.

The mixed powder is preferably fired under a pressure not less than the atmospheric pressure. Since the silicon nitride decomposes easily, it is advantageous to fire the mixture under a pressure not less than the atmospheric pressure. In order to prevent the silicon nitride from decomposition at a high temperature, the pressure is preferably 5 atm or more and the firing temperature is preferably in the range of 1500 to 2000°C. If those conditions are satisfied, the aimed fired product can be obtained without suffering from troubles such as sublimation of the raw materials and/or of the product. The firing temperature is more preferably in the range of 1800 to 2000°C.

For the purpose of avoiding oxidation of AIN, the firing step is preferably carried out in a nitrogen atmosphere. The atmosphere may contain hydrogen in an amount of about 90 at.% or less.

After the firing step is carried out at the above temperature for 0.5 to 10 hours, preferably 1 to 4 hours, the fired product is taken out of the crucible and then ground. The ground product is preferably fired again under the same conditions. If those firing and grinding procedures are repeated from 0 to 10 times, the product has the advantages that the crystal grains are less fused, and further, the composition and the crystal structure of the formed powder are more uniform.

The firing step can be carried out according to single-stage firing under a single set of firing conditions, but also can be carried out according to multistage firing under two or more different sets of firing conditions in combination. Specifically, the mixed powder can be fired in a mixed gas atmosphere of hydrogen and nitrogen under atmospheric pressure, and then successively fired again in a nitrogen atmosphere under increased pressure. More specifically, the phosphor having excellent luminescent properties can be formed by the firing step comprising the following stages:
(1) first stage
   atmosphere : mixed gas atmosphere comprising 10 to 90 mol% of hydrogen and 10 to 90 mol% of nitrogen;
   pressure : 0.9 to 2 atm;
   temperature : 1000 to 2000°C
   firing time : 1 to 20 hours
(2) second stage
   atmosphere : mixed gas atmosphere comprising 0 to 50 mol% of hydrogen and 50 to 100 mol% of nitrogen;
   pressure : 0.9 to 10 atm;
   temperature : 1400 to 2000°C
   firing time : 0.5 to 10 hours.

Those plural stages may be repeated twice or more.

After the firing step, the product is subjected to after-treatment such as washing, if necessary, to obtain a phosphor according to the embodiment. The washing can be carried out, for example, by using pure water or acid. Examples of the acid include: inorganic acids, such as sulfuric acid, nitric acid, hydrochloric acid and hydrofluoric acid; organic acids, such as formic acid, acetic acid and oxalic acid; and mixtures thereof.

After washed with acid, the product may be subjected to post-annealing treatment, if necessary. The post-annealing treatment, which can be carried out, for example, in a reductive atmosphere containing nitrogen and hydrogen, improves the crystallinity and the luminous efficiency.

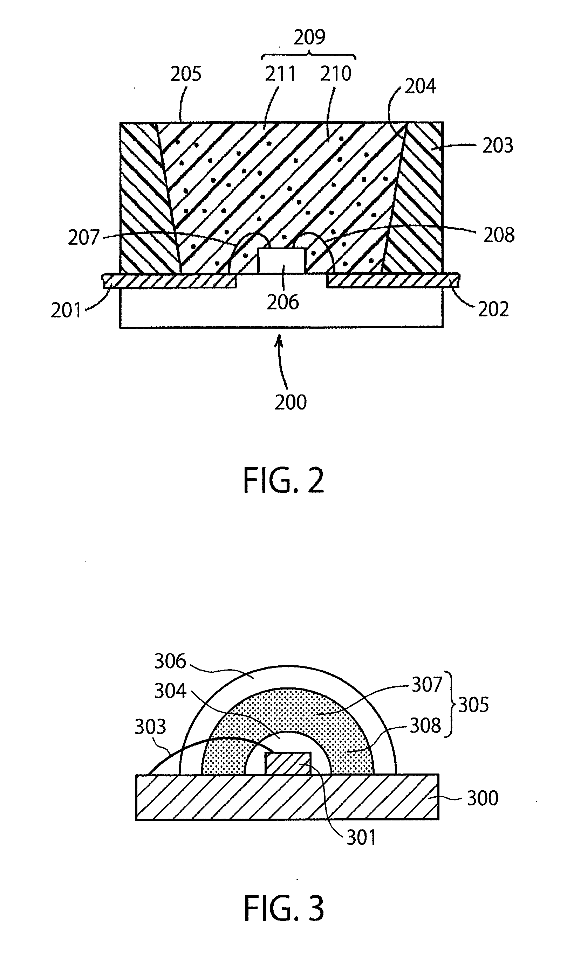

The light-emitting device according to the embodiment comprises a luminescent layer containing the above phosphor and a light-emitting element capable of exciting the phosphor. Figure 2 shows a vertical sectional view schematically illustrating a light-emitting device according to an embodiment of the present disclosure.

The light-emitting device shown in Figure 2 comprises leads 201, 202 and a package cup 203 on a substrate 200. The package cup 203 and the substrate 200 are made of resin. The package cup 203 has a concavity 205 in which the top opening is larger than the bottom. The inside wall of the concavity 205 functions as a reflective surface 204.

At the center of the nearly circular bottom of the concavity 205, there is a light-emitting element 206 mounted with Ag paste or the like. The light-emitting element 206 radiates light with a peak in the wavelength range of 400 to 500 nm. Examples of the light-emitting element 206 include light-emitting diodes and laser diodes, such as GaN type semiconductor light-emitting chips, but they by no means restrict the light-emitting element.

The p- and n-electrodes (not shown) of the light-emitting element 206 are connected to the leads 201 and 202 by way of bonding wires 207 and 208 made of Au or the like, respectively. The positions of the leads 201 and 202 can be adequately modified.

The light-emitting element 206 may be of a flip chip type in which the n- and p-electrodes are placed on the same plane. This element can avoid troubles concerning the wires, such as disconnection or dislocation of the wires and light-absorption by the wires. In that case, therefore, it is possible to obtain a semiconductor light-emitting device excellent both in reliability and in luminance. Further, it is also possible to adopt a light-emitting element having an n-type substrate so as to produce a light-emitting device constituted as described below. In that device, an n-electrode is formed on the back surface of the n-type substrate while a p-electrode is formed on the top surface of a p-type semiconductor layer beforehand laid on the substrate. The n-electrode is mounted on one of the leads, and the p-electrode is connected to the other lead by way of a wire.

In the concavity 205 of the package cup 203, there is a luminescent layer 209 containing the phosphor 110 according to an embodiment of the present disclosure. In the luminescent layer 209, the phosphor 210 is contained in a resin layer 211 made of, for example, silicone resin in an amount of 5 to 60 wt%. As described above, the phosphor according to the embodiment comprises Sr₂Al₃Si₇ON₁₃ matrix. Since that kind of oxynitride has high covalency, the phosphor of the embodiment is generally so hydrophobic that it has good compatibility with the resin. Accordingly, scattering at the interface between the resin and the phosphor is prevented enough to improve the light-extraction efficiency.

The yellow light-emitting phosphor according to the embodiment has good temperature dependence, and can efficiently emit yellow light with a wide half-width emission spectrum. This phosphor is used in combination with a light-emitting element radiating light with a peak in the wavelength range of 400 to 500 nm, and thereby it becomes possible to provide a white light-emitting device excellent in luminescent properties.

The size and kind of the light-emitting element 206 and the dimension and shape of the concavity 205 can be properly changed.

The light-emitting device according to an embodiment of the present disclosure is not restricted to the package cup-type shown in Figure 2, and can be freely applied to any type of devices. For example, even if the phosphor of the embodiment is used in a shell-type or surface-mount type LED, the same effect can be obtained.

Figure 3 shows a vertical sectional view schematically illustrating a light-emitting device according to another embodiment of the present disclosure. In the shown device, p- and n-electrodes (not shown) are formed at the predetermined positions on a heat-releasing insulating substrate 300, and a light-emitting element 301 is placed thereon. The heat- releasing insulating substrate is made of, for example, AIN.

On the bottom of the light-emitting element 301, one of the electrodes of the element is provided and electrically connected to the n-electrode of the heat-releasing insulating substrate 300. The other electrode of the light-emitting element 301 is connected to the p-electrode (not shown) on the heat-releasing insulating substrate 300 by way of a gold wire. The light-emitting element 301 is a light-emitting diode radiating light with a peak in the wavelength range of 400 to 500 nm.

The light-emitting element 301 is successively domed with an inner transparent resin layer 304, a luminescent layer 305 and an outer transparent resin layer 306 in this order. The inner and outer transparent resin layers 304 and 306 are made of, for example, silicone resin. In the luminescent layer 305, the yellow light-emitting phosphor 307 according to the embodiment is dispersed in a resin layer 308 made of, for example, silicone resin.

In the production process of the light-emitting device shown in Figure 3, the luminescent layer 305, which contains the yellow light-emitting phosphor of the embodiment, can be easily formed by use of techniques such as vacuum printing and drop-coating from a dispenser. Further, since positioned between the inner and outer transparent resin layers 304 and 306, the luminescent layer 305 also has the function of improving the extraction efficiency.

The luminescent layer in the light-emitting device according to the embodiment may contain not only the yellow-light emitting phosphor of the embodiment but also another phosphor emitting green luminescence under excitation by blue light and still another phosphor emitting red luminescence under excitation by blue light. If comprising that luminescent layer, the produced white light-emitting device is further improved in color rendering properties.

Even when excited by UV light with a peak in the wavelength range of 250 to 400 nm, the yellow-light emitting phosphor of the embodiment radiates yellow luminescence. Accordingly, the phosphor of the embodiment can be combined with, for example, another phosphor emitting blue light under excitation by UV light and a light-emitting element such as a UV light-emitting diode, to produce a white light-emitting device. In that white light-emitting device, the luminescent layer may contain not only the yellow-light emitting phosphor of the embodiment but also a phosphor emitting luminescence with a peak in another wavelength range under excitation by UV light. That phosphor is, for example, a phosphor emitting red light under excitation by UV light or a phosphor emitting green light under excitation by UV light.

As described above, the phosphor according to the embodiment has good temperature dependence characteristics, and can efficiently emit yellow light with an emission spectrum having a wide half-width. That yellow-light emitting phosphor of the embodiment is combined with a light-emitting element radiating light with a peak in the wavelength range of 250 to 500 nm, and thereby it becomes possible to produce a white light-emitting device excellent in luminescent properties by use of fewer kinds of phosphors.

The following are concrete examples of the phosphor and the light-emitting device according to the embodiment.

### Example 1

As the raw materials containing Sr, Ce, Si and Al, SrSi₂, CeCl₃, Si₃N₄ and AIN were prepared and weighed out in the blending amounts of 4.416 g, 0.185 g, 2.474 g and 1.414 g, respectively. The materials were then dry-mixed in a planetary ball mill.

The obtained mixture was laid in a crucible made of boron nitride (BN) and then fired at 1600°C for 4 hours under 1 atm in a hydrogen/nitrogen atmosphere. The fired product was taken out of the crucible, and then ground in an agate mortar. The ground product was laid again in the crucible, and fired at 1600°C for 4 hours. Those procedures of taking out, grinding and firing were repeated once more.

The obtained mixture was laid in the crucible made of boron nitride (BN), and fired at 1850°C for 4 hours under 7.5 atm in a nitrogen atmosphere. The fired product was taken out of the crucible, and then ground in an agate mortar. The ground product was laid again in the crucible, and fired again at 1850°C for 4 hours. Those procedures of taking out, grinding and firing were repeated twice more, to obtain the phosphor of Example 1. The obtained phosphor was in the form of yellow powder, and was observed to emit yellow luminescence when excited by black light.

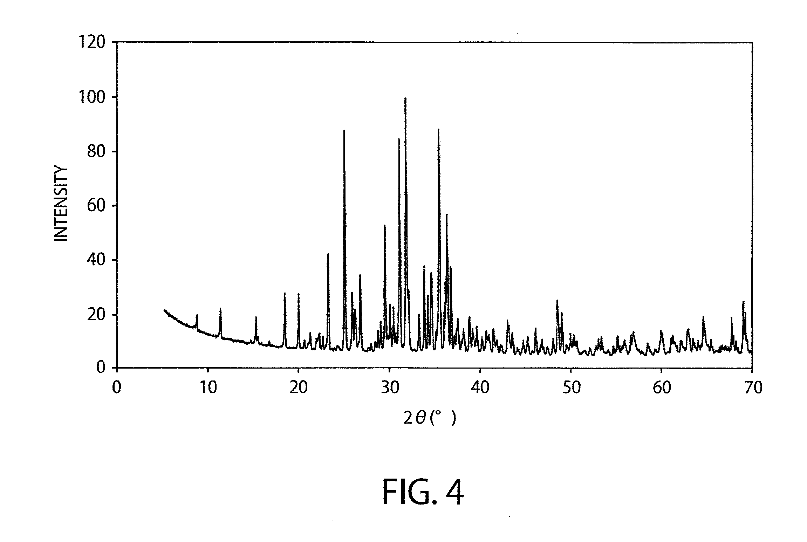

This phosphor exhibited an XRD profile shown in Figure 4. The XRD profile was measured with Cu-Kα line radiation according to Bragg-Brendano method. As shown in Figure 4, there were peaks in the diffraction angles (2θs) of 8.45-8.75°, 11.1-11.4°, 18.2-18.5°, 19.7-20.0°, 23.0-23.3°, 24.8-25.1°, 25.65-25.95°, 26.55-26.85°, 29.3-29.6°, 29.8-30.1°, 30.2-30.5°, 30.9-31.2°, 31.55-31.85°, 33.55-33.85°, 33.9-34.2°, 34.35-34.65°, 35.2-35.5°, 36.0-36.3°, 36.5-36.8°, 48.3-48.6°, and 48.7-49.0°.

Table 2 shows relative intensities of the peaks in the XRD profile of Figure 4.

**Table 2**

| 2*θ*(°) | Relative intensity |
|---|---|
| 8.62 | 20 |
| 11.22 | 22 |
| 18.37 | 28 |
| 19.86 | 28 |
| 23.14 | 42 |
| 24.98 | 88 |
| 25.79 | 28 |
| 26.05 | 22 |
| 26.68 | 34 |
| 29.42 | 53 |
| 31.03 | 85 |
| 31.71 | 100 |
| 33.70 | 38 |
| 34.48 | 35 |
| 35.35 | 88 |
| 36.21 | 57 |
| 36.63 | 37 |
| 48.42 | 25 |
| 48.88 | 20 |

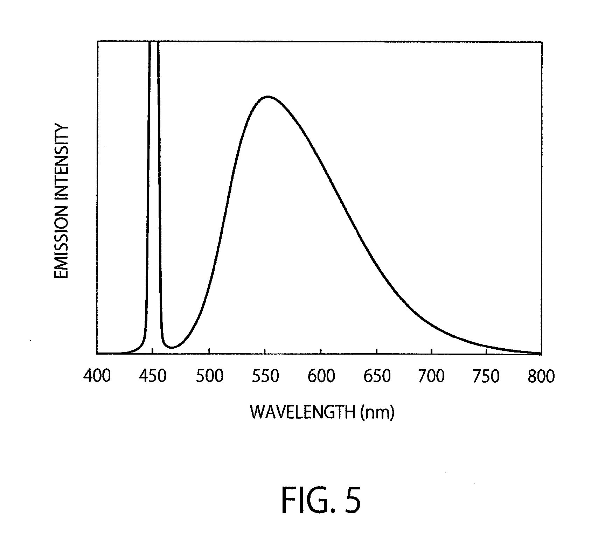

Figure 5 shows an emission spectrum of the phosphor produced in Example 1 under excitation by exciting light of a xenon lamp at 450 nm. In Figure 5, the narrow band at about 450 nm is attributed not to the luminescence of the phosphor but to reflection of the exciting light. The emission spectrum shows an intense luminescence with a peak at 551 nm, and the half-width thereof was measured to be found 117 nm by means of a multi-channel spectrophotometer. The half-width can be regarded as an index for color rendering properties of white light radiated from the light-emitting device. Generally, the larger the half-width is, the more easily white light having excellent color rendering properties can be obtained. Since having the half-width of 117 nm, the phosphor of Example 1 was found to readily provide white light having excellent color rendering properties.

### Example 2

The procedure of Example 1 was repeated except that the blending amounts of SrSi₂ and CeCl₃ were changed to 4.348 g and 0.296 g, respectively, to obtain the phosphor of Example 2.

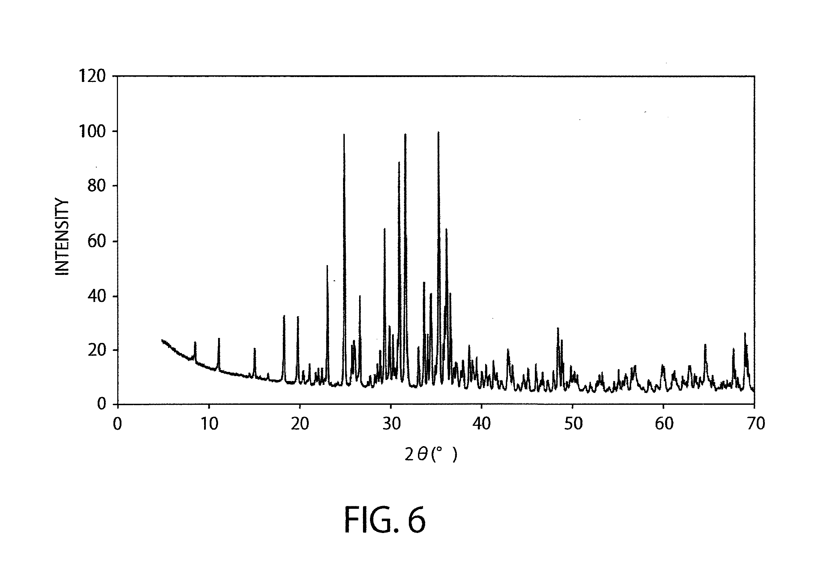

The phosphor of Example 2 was in the form of yellow powder, and was observed to emit yellow luminescence when excited by black light. This phosphor exhibited an XRD profile shown in Figure 6. As shown in Figure 6, there were peaks in the diffraction angles (2θs) of 8.45-8.75°, 11.1-11.4°, 18.2-18.5°, 19.7-20.0°, 23.0-23.3°, 24.8-25.1°, 25.65-25.95°, 26.55-26.85°, 29.3-29.6°, 29.8-30.1°, 30.2-30.5°, 30.9-31.2°, 31.55-31.85°, 33.55-33.85°, 33.9-34.2°, 34.35-34.65°, 35.2-35.5°, 36.0-36.3°, 36.5-36.8°, 48.3-48.6°, and 48.7-49.0°.

Table 3 shows relative intensities of the peaks in the XRD profile of Figure 6.

**Table 3**

| 2*θ*(°) | Relative intensity |
|---|---|
| 8.62 | 23 |
| 11.21 | 24 |
| 15.13 | 21 |
| 18.37 | 33 |
| 19.89 | 32 |
| 20.49 | 12 |
| 21.15 | 15 |
| 23.14 | 51 |
| 24.97 | 99 |
| 25.81 | 22 |
| 26.67 | 40 |
| 29.41 | 65 |
| 29.94 | 29 |
| 30.31 | 26 |
| 31.03 | 89 |
| 31.69 | 99 |
| 33.69 | 45 |
| 34.07 | 26 |
| 34.49 | 41 |
| 35.35 | 100 |
| 35.87 | 23 |
| 36.04 | 37 |
| 36.21 | 65 |
| 36.62 | 41 |

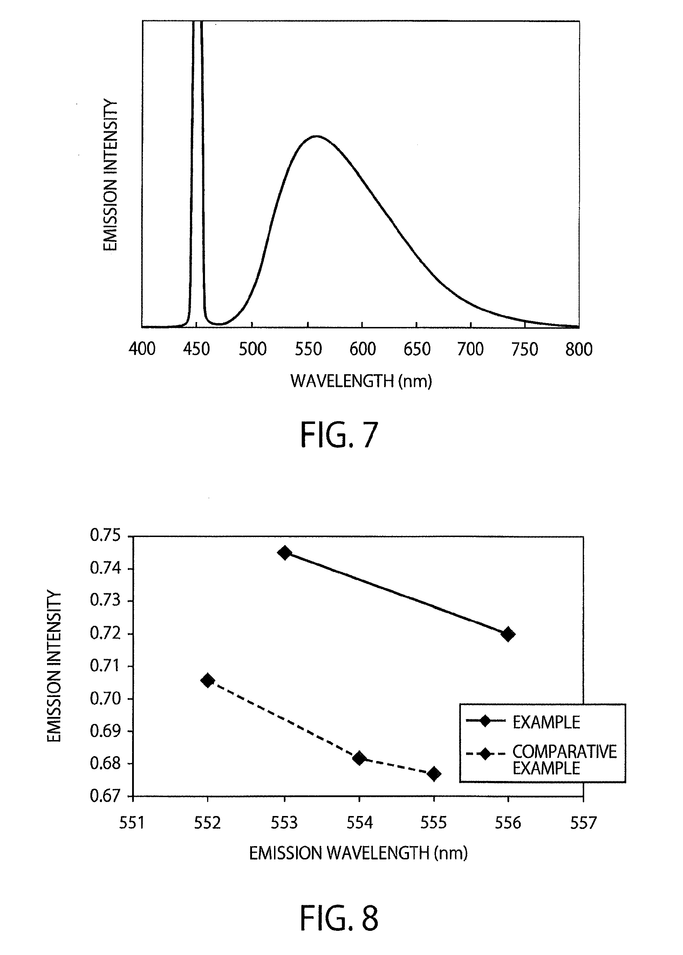

Figure 7 shows an emission spectrum of the phosphor produced in Example 2 under excitation by exciting light of a xenon lamp at 450 nm.

### Comparative examples 1 to 3

The phosphors of Comparative examples 1 to 3 were produced in the following manner. As the raw materials containing Sr, Ce, Si and Al, Sr₃N₂, CeCl₃, Si₃N₄ and AIN, respectively, were prepared and weighed out in the blending amounts shown in Table 4. The materials were then dry-mixed in a planetary ball mill.

**Table 4**

| | Sr₃N₂ | CeCl₃ | Si₃N₄ | AlN |
|---|---|---|---|---|
| Comparative example 1 | 2.993 | 0.155 | 5.647 | 1.414 |
| Comparative example 2 | 2.963 | 0.233 | 5.647 | 1.414 |
| Comparative example 3 | 2.932 | 0.311 | 5.647 | 1.414 |

The obtained mixture was laid in a crucible made of boron nitride (BN) and then fired at 1600°C for 4 hours under 1 atm in a hydrogen/nitrogen atmosphere. The fired product was taken out of the crucible, and then ground in an agate mortar. The ground product was laid again in the crucible, and fired at 1600°C for 4 hours. Those procedures of taking out, grinding and firing were repeated once more.

The obtained mixture was laid in the crucible made of boron nitride (BN), and fired at 1850°C for 4 hours under 7.5 atm in a nitrogen atmosphere. The fired product was taken out of the crucible, and then ground in an agate mortar. The ground product was laid again in the crucible, and fired at 1850°C for 4 hours. Those procedures of taking out, grinding and firing were repeated twice more, to obtain the phosphor of each Comparative example. Each obtained phosphor was in the form of yellow powder, and was observed to emit yellow luminescence when excited by black light.

### [Evaluation]

As for the phosphors of Examples 1 and 2 and Comparative examples 1 and 3, the results of the composition analysis are shown in Table 5. The values in Table 5 are expressed in terms of molar ratios normalized so that the molar concentrations of Si and Al may be 10 in total.

**Table 5**

| | Sr | Ce | Sr+Ce | Al | Si | O | N |
|---|---|---|---|---|---|---|---|
| Example 1 | 1.79 | 0.049 | 1.84 | 2.23 | 7.77 | 0.3 | 13 |
| Example 2 | 1.75 | 0.081 | 1.83 | 2.23 | 7.77 | 0.4 | 14 |
| Comparative example 1 | 1.87 | 0.043 | 1.91 | 2.30 | 7.70 | 0.3 | 13 |
| Comparative example 3 | 1.85 | 0.088 | 1.94 | 2.30 | 7.70 | 0.4 | 14 |

Table 6 and Figure 8 show the emission wavelength and the luminous efficiency of the above phosphors under excitation by exciting light of a xenon lamp at 450 nm. It was found that the phosphors of Examples emit luminescence more efficiently than those of Comparative examples.

**Table 6**

| | Emission wavelength (nm) | Luminous efficiency |
|---|---|---|
| Example 1 | 553 | 0.74 |
| Example 2 | 556 | 0.71 |
| Comparative example 1 | 552 | 0.71 |
| Comparative example 2 | 554 | 0.68 |
| Comparative example 3 | 555 | 0.68 |

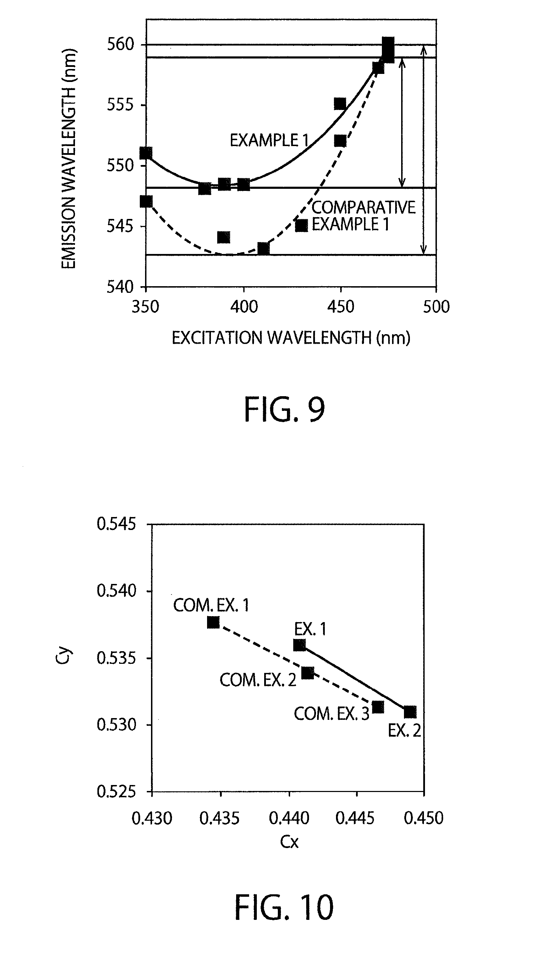

Further, as for the phosphors of Example 1 and Comparative example 1, the peak wavelength of the emission spectrum and the shift thereof were measured while the excitation wavelength was changed in the range of 350 to 475 nm. The results are shown in Figure 9.

When the excitation wavelength was changed in the range of 350 to 475 nm, the phosphor of Comparative example 1 showed the emission wavelength changing in the range of 543 to 560 nm and hence the shift was almost 20 nm. This is presumed to be attributed to unevenness of the composition or structure among and in the phosphor particles. On the other hand, under excitation changed in the same range, the phosphor of Example 1 showed the emission wavelength changing in the range of 548 to 559 nm and hence the shift was about 10 nm, which is smaller than that of Comparative example 1. This is thought to be because the phosphor of the embodiment has high evenness among and in the particles.

Also, as for the phosphors of Example 2 and Comparative examples 2 and 3, the shift of the emission peak wavelength was measured in the same manner. The results are shown in Table 7.

**Table 7**

| | Emission wavelength shift (nm) |
|---|---|
| Example 1 | 11 |
| Example 2 | 11 |
| Comparative example 1 | 17 |
| Comparative example 2 | 18 |
| Comparative example 3 | 18 |

Figure 10 shows chromaticities of those phosphors excited at 450 nm. It was found that, since improved in evenness of the composition or structure, the phosphor of the present embodiment is improved not only in efficiency but also in chromaticity as shown in Figure 10. Improvement of the phosphor in efficiency directly leads to improvement of the white LED in efficiency. In addition, since the phosphor is also improved in chromaticity, the content of the phosphor in the white LED can be decreased enough to reduce efficiency-loss caused by scattering of the phosphor and consequently the white LED can be further improved in efficiency.

### Application example

A light-emitting device having the structure of Figure 3 was produced by using the phosphor of Example 1.

First, an 8-mm-square AIN substrate provided with p- and n-electrodes (not shown) thereon at the predetermined positions was prepared as the insulating substrate 300. On the substrate, a light-emitting diode showing an emission peak at 460 nm was soldered as the light-emitting element 301. One electrode of the light-emitting element 301 was provided on the bottom thereof and electrically connected to the n-electrode of the AIN substrate 300. The other electrode of the element 301 was connected to the p-electrode (not shown) of the AIN substrate 300 by way of a gold wire 303.

Subsequently, the light-emitting element 301 was successively domed with an inner transparent resin layer 304, a luminescent layer 305 and an outer transparent resin layer 306 in this order, to produce a light-emitting device of the embodiment. The inner transparent resin layer 304 was made of silicone resin, and was formed by use of a dispenser. The luminescent layer 305 was made of a transparent resin containing the phosphor of Example 1 in an amount of 50 wt%. As the transparent resin, silicone resin was adopted. The luminescent layer 305 was then covered with an outer transparent resin layer 306 made of the same silicone resin as the inner transparent resin layer 304.

The produced device was placed in an integrating sphere, and then worked with 20 mA and 3.3 V. The radiated light was observed and found to have a color temperature of 6300K, a luminous flux efficiency of 180 lm/W and Ra=76. Those color temperature, luminous flux efficiency and Ra were measured by means of a multi-channel spectrophotometer.

Thus, the phosphor of Example 1 was combined with a blue LED showing an emission peak at 460 nm to produce a white light-emitting device of the embodiment. This white light-emitting device can be used as a high-power white LED product excellent in both luminous efficiency and color rendering properties.

The embodiment of the present disclosure provides a phosphor capable of efficiently emitting yellow light with favorable chromaticity. The yellow light-emitting phosphor of the embodiment can be combined with a blue LED to obtain a white light-emitting device excellent in both color rendering properties and luminescent properties.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the inventions.

## Claims

1. A phosphor represented by the following formula (1):
((SrₚM₁₋ₚ)₁₋ₓCeₓ)_{2y}Al_{z}Si_{10-z}OᵤN_{w} (1)
in which
M is at least one of the alkaline earth metals, and p, x, y, z, u and w are numbers satisfying the conditions of
0≤p≤1,
0<x≤1,
0.8≤y≤1.1,
2≤z≤3.5,
0<u≤1,
1.8≤z-u, and
13≤u+w≤15;
said phosphor emiting luminescence with an emission peak in the wavelength range of 500 to 600 nm under excitation by exciting light having a peak in the wavelength range of 250 to 500 nm,
wherein
said emission peak shifts within a range of less than 15 nm when said peak of exciting light is changed in the range of 350 to 475 nm.

2. The phosphor according to claim 1, wherein M is at least one selected from the group consisting of Ba, Ca and Mg.

3. The phosphor according to claim 1, wherein said number p is not larger than 0.1.

4. The phosphor according to claim 1, showing at least ten peaks in the diffraction angles (2θs) of 8.45 to 8.75°, 11.1 to 11.4°, 18.2 to 18.5°, 19.7 to 20.0°, 23.0 to 23.3°, 24.8 to 25.1°, 25.65 to 25.95°, 26.55 to 26.85°, 29.3 to 29.6°, 29.8 to 30.1°, 30.2 to 30.5°, 30.9 to 31.2°, 31.55 to 31.85°, 33.55 to 33.85°, 33.9 to 34.2°, 34.35 to 34.65°, 35.2 to 35.5°, 36.0 to 36.3°, 36.5 to 36.8°, 48.3 to 48.6°, and 48.7 to 49.0°, in X-ray diffraction measurement according to Bragg-Brendano method with Cu-Kα line radiation.

5. A light-emitting device comprising
a light-emitting element radiating light with a peak in the wavelength range of 250 to 500 nm, and
a luminescent layer containing the phosphor according to claim 1.

6. A method for producing the phosphor according to claim 1, comprising the steps of
mixing
a material containing Sr selected from a silicide, a nitride or a carbide of Sr,
a material containing M selected from a silicide, a nitride or a carbide of M,
a material containing Al selected from a nitride, an oxide or a carbide of Al,
a material containing Si selected from a nitride, an oxide or a carbide of Si, and
a material containing Ce selected from an oxide, a nitride or a carbonate of Ce,
to prepare a mixture; and then
firing the mixture.

7. The method according to claim 6, wherein said materials containing Sr and M are silicides of Sr and M, respectively.

8. The method according to claim 6, wherein said mixture is prepared by dry-mixing the materials in powder form in the order of smaller to larger weights.

9. The method according to claim 6, wherein said step of firing is carried out according to multistage firing under two or more different sets of firing conditions in combination.

10. The method according to claim 6, wherein said mixture is fired in a mixed gas atmosphere of hydrogen and nitrogen under atmospheric pressure and then successively fired again in a nitrogen atmosphere under increased pressure.

11. The method according to claim 10, wherein said firing procedure under increased pressure is carried out according to single-stage firing at a temperature of 1500 to 2000°C under 5 atm or more.

12. The method according to claim 10, wherein said firing procedure under increased pressure is carried out in a nitrogen atmosphere.
